# EUROPÄISCHE PATENTANMELDUNG

(11) **EP 2 636 767 A1**
(43) Veröffentlichungstag der Anmeldung: **11.09.2013**
(21) Anmeldenummer: 12179680.9
(22) Anmeldetag: 08.08.2012
(51) Int. Cl.: C23C 16/24, C23C 16/44

(54) **Laborreaktor**

(30) Priorität: 08.03.2012 DE 202012100839 U
(71) Anmelder: SilConTec GmbH, 5122 Hochburg-Ach (AT)
(72) Erfinder: Menzel, Christian, 5133 Gilgenberg am Weilhart (AT); Winkler, Josef, 5121 Tarsdorf (AT)
(74) Vertreter: Gustorf, Gerhard

(57) **Zusammenfassung**

Der Laborreaktor dient zur Abscheidung von Polysilizium aus einem Prozessgas auf einem Dünnstab (62) aus Silizium, der innerhalb einer Haube (20) zwei Elektroden (34) überbrückt, die in eine Bodenplatte (18) eingesetzt sind. Dabei ist vorgesehen dass die Innenwand (80) der Haube (20) sowie die nach innen weisende Bodenfläche (44) der Bodenplatte (18) mit Silber beschichtet sind und dass auch der den Dünnstab (62) aufnehmende Kopf (56) der beiden Elektroden (34) versilbert ist. In Weiterbildung der Erfindung haben die Elektroden (34) einen wassergekühlten Hohlraum (48).

## Beschreibung

Die Erfindung betrifft einen Laborreaktor zur Abscheidung von Polysilizium aus einen Prozessgas auf einen Dünnstab aus Silizium, der innerhalb einer Haube zwei Elektroden überbrückt, die in eine Bodenplatte eingesetzt sind.

Zur Gewinnung von Silizium werden nach dem Siemens-Verfahren bei sehr hohen Temperaturen aus einem Prozessgas Siliziumatome abgeschieden, die sich auf einem Träger ablagern. Dieser Vorgang wird in großen Reaktoren unter Luftabschluss durchgeführt, wobei erhebliche Anforderungen an die Reinheit beachtet werden müssen.

Der Erfindung liegt die Aufgabe zugrunde, einen Laborreaktor zur Verfügung zu stellen, der bei laufendem Prozess eine Qualitätsanalyse und Qualitätssicherung erlaubt, damit Unreinheiten bei der Abscheidung des Siliziums frühzeitig online festgestellt werden können, um in den Produktionsvorgang eingreifen zu können.

Zur Lösung dieser Aufgabe dient der gemäß der Erfindung ausgebildete Laborreaktor, der sich dadurch auszeichnet, dass die Innenwand der Haube sowie die nach innen weisende Bodenfläche der Bodenplatte mit Silber beschichtet sind und dass auch der den Dünnstab aufnehmende Kopf der beiden Elektroden versilbert ist.

Die erfindungsgemäß vorgesehene Silberbeschichtung hat den doppelten Vorteil, dass einerseits die Reinheit im Laborreaktor gewährleistet ist und dass andererseits ein homogenes Temperaturfeld mit hohen Temperaturen realisiert werden kann, wobei der Energieverbrauch merklich verringert wird.

In Weiterbildung der Erfindung haben die beiden Elektroden einen wassergekühlten Hohlraum, wozu jede Elektrode aus einem an eine Spannungsquelle angeschlossenen, elektrisch leitenden Rohr besteht, in das koaxial ein Kühlwasserrohr eingesetzt ist. Sowohl das elektrisch leitende Rohr der Elektrode als auch das Kühlwasserrohr können nach einem weiteren Merkmal der Erfindung aus Kupfer oder einer Kupferlegierung bestehen.

Die wassergekühlten Elektroden des Laborreaktors gemäß der Erfindung und deren versilberter Kopf haben den Vorteil der Stabilisierung einer gleichbleibenden, verhältnismäßig niedrigen Temperatur an den Übergängen der Elektroden auf den Silizium-Dünnstab.

In Weiterbildung der Erfindung ist der über die Bodenplatte in die Haube ragende Kopf jeder Elektrode als Konus ausgebildet, auf den ein konischer Graphitkopf formschlüssig aufgesteckt ist, der eine Sackbohrung zur Aufnahme des unteren Endes des jeweiligen Dünnstabes hat. Dabei ist es von Vorteil, wenn die Sackbohrung nach außen konisch erweitert ist, wodurch eine reibschlüssige Fixierung des Dünnstabes gewährleistet wird.

Nach einem weiteren Merkmal der Erfindung ist die Haube über eine Glocke aus Quarzglas gestülpt, das eine Sicht auf den Dünnstab während des Prozesses erlaubt und absolut rein ist.

In dem für eine Stickstofffüllung vorgesehenen Ringraum zwischen Haube und Glocke kann nach einem weiteren Merkmal der Erfindung ein elektrisches Vorheizelement angeordnet sein, beispielsweise eine Vorheizlampe.

Weitere Merkmale und Vorteile der Erfindung ergeben sich aus den Ansprüchen und aus der folgenden Beschreibung eines Ausführungsbeispiels, das in der Zeichnung dargestellt ist. In dieser zeigen:
- Figur 1: die Ansicht eines geöffneten Kabinets mit darin untergebrachtem Laborreaktor gemäß der Erfindung,
- Figur 2: eine schematische Schnittdarstellung des Laborreaktors gemäß der Erfindung,
- Figur 3: im vergrößertem Maßstab eine der beiden Elektroden und
- Figur 4: eine Variante der Figur 3.

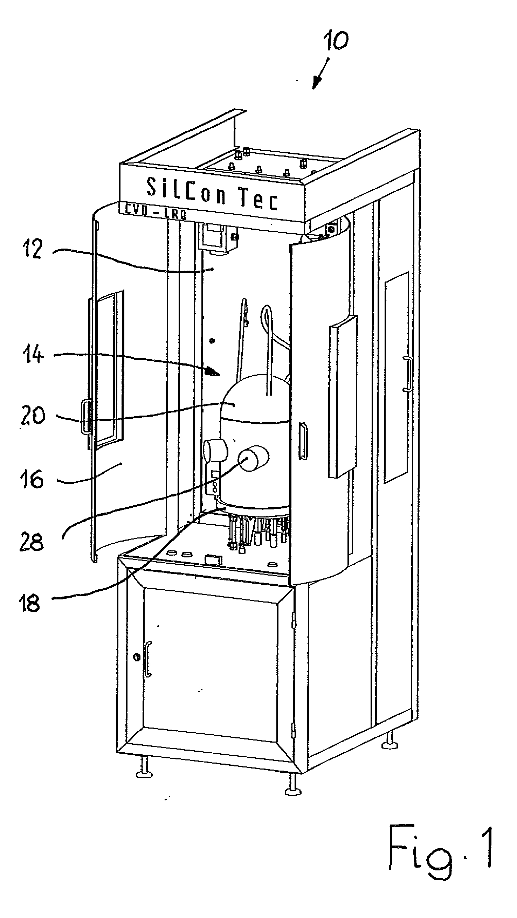

Figur 1 zeigt die Ansicht eines Gehäuses 10 in Form eines Schrankes, der in seinem oberen Teil ein Kabinett 12 hat, in dem ein Laborreaktor 14 gemäß der Erfindung untergebracht ist. Das Kabinett 12 hat zwei um wenigstens je 90° schwenkbare Flügeltüren 16, so dass der Innenraum des Kabinetts 12 leicht und ungehindert zugänglich ist.

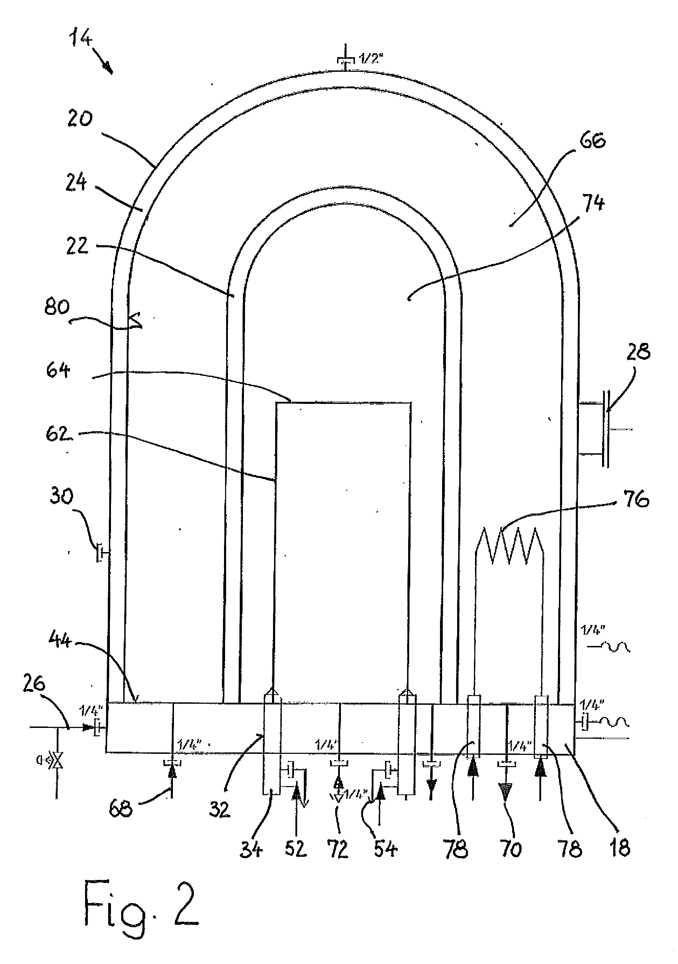

Wie die Schnittdarstellung der Figur 2 zeigt, hat der Laborreaktor 14 eine Bodenplatte 18, auf der über nicht weiter dargestellte Klemmverschraubungen eine Haube 20 befestigt ist. Diese schließt eine kleinere, ebenfalls haubenförmige Glocke 22 ein, die aus Quarzglas besteht.

Die doppelwandig ausgebildete Außenhaube 20 aus Edelstahl hat zwischen den beiden Wänden einen wassergekühlten Hohlraum 24. Zur weiteren Kühlung des Laborreaktors 14 ist auch die aus Edelstahl bestehende Bodenplatte 18 hohl und an einer Seite mit einem Kühlwasseranschluss 26 versehen.

An einer Seite hat die Haube 20 ein Kupplungselement 28, an dem eine nicht weiter dargestellte Hubvorrichtung angreifen kann, um den gesamten Laborreaktor 14 transportieren und heben zu können.

Auf der dem Kupplungselement 28 gegenüberliegende Seite der Haube 20 ist ein Schauglas 30 vorgesehen, durch das der Innenraum des Laborreaktors 14 eingesehen werden kann.

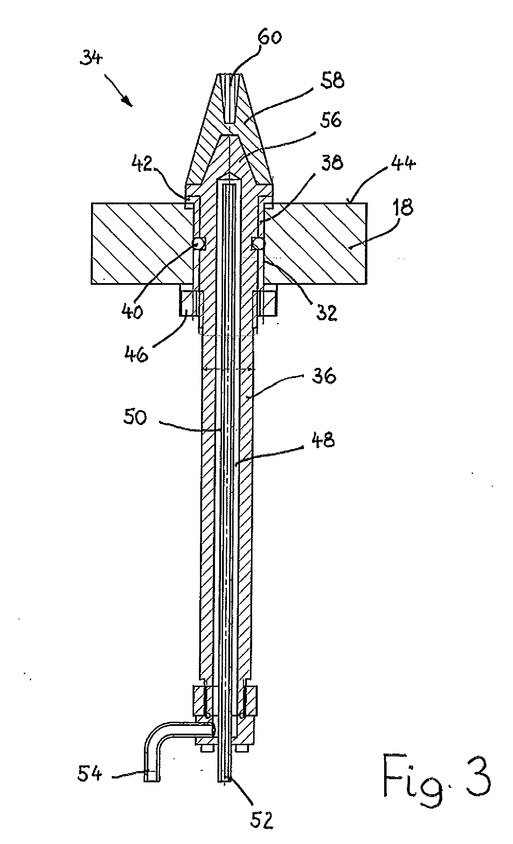

Im mittleren Bereich der Bodenplatte 18 sind zwei vertikale Aufnahmebohrungen 32 vorgesehen, in die jeweils eine in Figur 3 näher dargestellte Elektrode 34 von oben eingesteckt ist. Die Elektrode 34 besteht aus einem elektrisch leitenden, zylindrischen Rohr 36, das aus Kupfer oder einer Kupferlegierung hergestellt ist. Das Rohr 36 ist gegen die Bodenplatte 18 durch eine Buchse 38 aus elektrisch nichtleitendem Material isoliert und durch einen O-Ring 40 abgedichtet. Die Buchse 38 stützt sich über einen Flansch 42 auf der Bodenfläche 44 der Bodenplatte 18 ab. Zur axialen Befestigung des Rohres 36 an der Bodenplatte 18 dient eine Ringmutter 46.

In den axialen Hohlraum 48 des Rohres 36 ist ein Kühlwasserrohr 50 eingesetzt, das ebenfalls aus Kupfer oder einer Kupferlegierung bestehen kann. Das Kühlwasserrohr 50 hat an seinem unteren Ende eine Eintrittsöffnung 52 für das Kühlwasser, welches am oberen, offenen Ende des Kühlwasserrohres 50 in den Hohlraum 48 eintritt und diesen am unteren Ende über einen Ablaufanschluss 54 verlässt.

Wie Figur 3 weiter zeigt, ist der Kopf 56 der Elektrode 34 als Konus ausgebildet, auf den ein konischer Graphitkopf 58 formschlüssig aufgesteckt ist. Der Graphitkopf 58 hat eine konisch nach außen erweiterte Sackbohrung 60, die zur Aufnahme des unteren Endes eines in Figur 2 angedeuteten Dünnstabes (Slimrod) 62 aus Silizium dient. Wie in Figur 2 weiter angedeutet ist, sind die beiden oberen Enden der Dünnstäbe 62 durch einen horizontalen, eine Brücke 64 bildenden Silizium-Dünnstab miteinander verbunden.

Aus Figur 2 geht ferner hervor, dass in den Ringraum 66 zwischen der Glocke 22 und der Haube 20 ein Eintrittsventil 68 führt, so dass der Ringraum 66 mit Stickstoff gefüllt werden kann. Auf der gegenüberliegenden Seite ist ein Auslassventil 70 für den Stickstoff vorgesehen.

Im Zentrum der Bodenplatte 18 befindet sich eine verschließbare Zuführöffnung 72 für den Eintritt eines Prozessgases in den Innenraum 74 der Glocke 22.

Im Ringraum 66 zwischen der Haube 20 und der Glocke 22 ist ein Vorheizelement 76, beispielsweise eine Vorheizlampe angeordnet, die über zwei Elektroden 78 an eine Spannungsquelle angeschlossen werden kann.

Gemäß der Erfindung ist schließlich vorgesehen, dass die Innenwand 80 der Außenhaube 20 als auch die Bodenfläche 44 der Bodenplatte 18 mit Silber beschichtet sind. Darüber hinaus ist auch der Kopf 56 der Elektrode 34 mit Silber beschichtet, wobei diese Silberbeschichtung die gesamte Fläche des Kopfes 56 bis zu dem in Figur 3 eingezeichneten O-Ring 40 einnimmt.

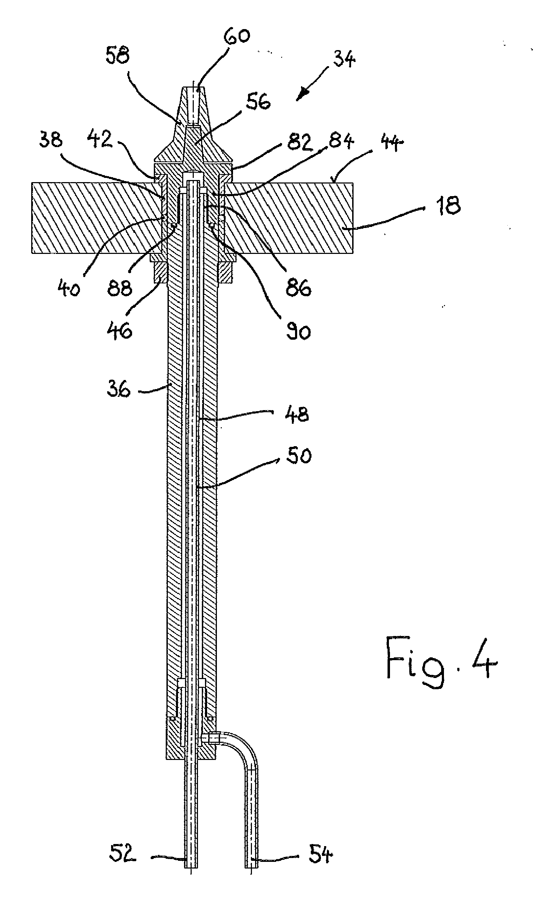

Figur 4 zeigt eine Variante der Figur 3, gemäß welcher der Kopf 56 der Elektrode 34 als ein von deren Rohr 36 getrenntes Bauelement 82 ausgebildet ist und einen rohrförmigen Fuß 84 hat, der auf einen rohrförmigen Hals 86 des zylindrischen Rohres 36 aufgesetzt ist. Der Fuß 84 endet in Höhe der O-Rings 40 oder kurz unterhalb von diesem und stüzt sich mit seinem unteren Ende auf einem Dichtungsring 88 ab, der in eine Ringnut 90 des zylindrischen Rohres 36 der Elektrode 34 eingelegt ist. Auch bei dieser Variante ist das aus Kopf 56 und Fuß 84 bestehende Bauelement 82 mit Silber beschichtet oder besteht insgesamt aus Silber.

Für den Betrieb des Laborreaktors 14 werden zunächst die beiden Dünnstäbe 62 mit der Dünnstab-Brücke 64 aus Silizium in die Sackbohrungen 60 der beiden Elektroden 34 eingesteckt, worauf die innere Glocke 22 und die äußere Haube 20 auf der Bodenplatte 18 befestigt werden. Im Anschluss daran muss dafür gesorgt werden, dass der gesamte Innenraum frei von Sauerstoff ist. Hierzu wird eine Stickstoffspülung vorgenommen, und zwar sowohl über die Zuführöffnung 72 für das Prozessgas als auch über das in den Ringraum 66 führende Eintrittsventil 68.

Zu Beginn des nun folgenden Prozesses werden die beiden Elektroden 34 an eine Spannungsquelle angeschlossen, die bis auf 400 Volt geregelt wird, so dass die Siliziumstäbe 62, 64 glühend werden und eine Temperatur von etwa 1000 °C erreichen. Bei dieser Temperatur wird über die Zuführöffnung 72 das Prozessgas eingeleitet, das aus TCS (Trichlorsilan) und Wasserstoff besteht. Bei der genannten, hohen Prozesstemperatur spaltet sich das TCS-Gas in HCl sowie Wasserstoff und Silan. Das im Silan enthaltene Silizium legt sich auf den Dünnstäben 62, 64 ab und wächst an diesen zu der gewünschten Stärke an. Da die erläuterte Abscheidung innerhalb weniger Stunden verhältnismäßig rasch abläuft, steht nach kurzer Zeit ein Testergebnis zur Verfügung, mit dem die Reinheit des gesamten Prozesses wesentlich rascher überprüft werden kann als in einem Großreaktor.

Nach Prozessende wird erneut eine Systemspülung mit Stickstoff durchgeführt.

Der Aufstellungsort des den Laborreaktor 14 aufnehmenden, in sich geschlossenen Kabinetts 12 ist unabhängig von einem Explosionsschutz, da das Kabinett 12 über ein nicht weiter dargestelltes Zu- und Abluftsystem verfügt, das von der Umluft unabhängig ist.

## Patentansprüche

1. Laborreaktor zur Abscheidung von Polysilizium aus einem Prozessgas auf einem Dünnstab (62) aus Silizium, der innerhalb einer Haube (20) zwei Elektroden (34) überbrückt, die in eine Bodenplatte (18) eingesetzt sind, **dadurch gekennzeichnet, dass** die Innenwand (80) der Haube (20) sowie die nach innen weisende Bodenfläche (44) der Bodenplatte (18) mit Silber beschichtet sind und dass auch der den Dünnstab (62) aufnehmende Kopf (56) der beiden Elektroden (34) versilbert ist.

2. Laborreaktor nach Anspruch 1, **dadurch gekennzeichnet, dass** die Elektrode (34) aus einem elektrisch leitenden Rohr (36) besteht, auf deren oberes Ende ein vom Rohr (36) getrennt ausgebildetes, versilbertes Bauteil (82) aufgesetzt ist, das aus einem rohrförmigen Fuß (82) und dem an diesem angeformten Kopf (56) besteht.

3. Laborreaktor nach Anspruch 1 oder 2, **dadurch gekennzeichnet, dass** die beiden Elektroden (34) einen wassergekühlten Hohlraum (48) haben.

4. Laborreaktor nach Anspruch 3, **dadurch gekennzeichnet, dass** jede Elektrode (34) aus einem an eine Spannungsquelle angeschlossenen, elektrisch leitenden Rohr (36) besteht, in das koaxial ein Kühlwasserrohr (50) eingesetzt ist.

5. Laborreaktor nach Anspruch 4, **dadurch gekennzeichnet, dass** sowohl das elektrisch leitende Rohr (36) der Elektrode (34) als auch das Kühlwasserrohr (50) aus Kupfer oder einer Kupferlegierung bestehen.

6. Laborreaktor nach einem der vorhergehenden Ansprüche, **dadurch gekennzeichnet, dass** der über die Bodenplatte (18) in die Haube (20) ragende Kopf (56) jeder Elektrode (34) als Konus ausgebildet ist, auf den ein konischer Graphitkopf (58) formschlüssig aufgesteckt ist, der eine Sackbohrung (60) zur Aufnahme des unteren Endes des jeweiligen Dünnstabes (62) hat.

7. Laborreaktor nach Anspruch 6, **dadurch gekennzeichnet, dass** die Sackbohrung (60) nach außen konisch erweitert ist.

8. Laborreaktor nach einem der vorhergehenden Ansprüche, **dadurch gekennzeichnet, dass** durch die Bodenplatte (18) eine verschließbare Zuführöffnung (72) für das Prozessgas in den Innenraum (74) der Haube (20) führt.

9. Laborreaktor nach einem der vorhergehenden Ansprüche, **dadurch gekennzeichnet, dass** die Haube (20) und die Bodenplatte (18) aus Edelstahl bestehen.

10. Laborreaktor nach Anspruch 9, **dadurch gekennzeichnet, dass** sowohl die Haube (20) als auch die Bodenplatte (18) wassergekühlte Hohlräume haben.

11. Laborreaktor nach einem der vorhergehenden Ansprüche, **dadurch gekennzeichnet, dass** die Haube (20) über eine Glocke (22) aus Quarzglas gestülpt ist, in deren Innenraum (74) die Zuführöffnung (72) für das Prozessgas mündet.

12. Laborreaktor nach Anspruch 11, **dadurch gekennzeichnet, dass** in dem Ringraum (66) zwischen Haube (20) und Glocke (22) ein elektrisches Vorheizelement (76) angeordnet ist.

13. Laborreaktor nach Anspruch 12, **dadurch gekennzeichnet, dass** der Ringraum (66) mit Stickstoff gefüllt ist.

14. Laborreaktor nach einem der vorhergehenden Ansprüche, **dadurch gekennzeichnet, dass** dieser in einem Kabinett (12) untergebracht ist, an das ein von der Umluft unabhängiges Zu- und Abluftsystem angeschlossen ist.

15. Laborreaktor nach Anspruch 14, **dadurch gekennzeichnet, dass** der Innenraum des Kabinetts (12) über zwei um wenigstens je 90° schwenkbare Flügeltüren (16) zugänglich ist.
